# EUROPEAN PATENT APPLICATION

(11) **EP 4 568 432 A1**
(43) Date of publication of application: **11.06.2025**
(21) Application number: 24211411.4
(22) Date of filing: 07.11.2024
(51) Int. Cl.: H05K 5/06, F21V 31/00, H02G 3/08

(54) **SEALING OF ENCLOSURE FROM WATER INGRESS VIA INTERLOCKING ENCLOSURE EDGES**

(30) Priority: 28.11.2023 US 202363603562 P; 16.09.2024 US 202418886104
(71) Applicant: Harman Professional Denmark ApS, 8200 Aarhus N (DK)
(72) Inventor: TOFT, Uffe Kjaergaard, 8200 Aarhus N (DK)
(74) Representative: Kraus & Lederer PartGmbB

(57) **Abstract**

Aspects of sealing of an enclosure are described. In some examples, an enclosure includes a first enclosure piece with a first edge. The first edge includes a first set of edge features. A second enclosure piece with a second edge includes a second set of edge features configured to interlock with the first set of edge features. When the first set of edge features interlock with the second set of edge features, a first projecting feature in the first edge overlaps a gap between a second projecting feature and a third projecting in the second edge.

## Description

### BACKGROUND

### Field of the Various Embodiments

This application relates to systems and methods for sealing enclosures, and more specifically, to sealing of enclosures from water ingress via interlocking enclosure edges.

### Description of the Related Art

An enclosure helps to prevent various types of physical, electrical, moisture, and other environmental damage to the contents of the enclosure. Gaskets, when properly disposed along the edge of an enclosure assembly for an electronic device, can prevent moisture, such as water droplets, from entering the enclosure and compromising moisture-sensitive components located within the enclosure.

However, one drawback of existing enclosures in the production, maintenance, and service of electronic devices, is the gasket. Gaskets are delicate parts that are prone to faulty assembly and failure over time and repeated assembly cycles. The gaskets may get squeezed or cut, may not stay in place when opening the electronic device up, or in some cases may be missing altogether. Thus, an electronic device that is assumed to have a certain level of moisture resistance may actually be susceptible to moisture ingress as a result of gasket failure.

Another drawback of existing enclosures is that the joining portions of the enclosures are fragile and prone to damage. The joining edges of the enclosures can be damaged from regular use, impacts, and from the connecting and disconnecting of joining edges. A further drawback of existing enclosures is that existing enclosures can have a short and direct path for water intrusion. If water enters a seam between joining edges of existing enclosures, the water can quickly pass through to the interior of the enclosure.

As the foregoing illustrates, what is needed in the art is an enclosure design that provides a stronger sealing structure between joining edges of the enclosure.

### SUMMARY

One embodiment of the present disclosure sets forth a system that includes a first enclosure piece with a first edge that includes a first plurality of projecting features; and a second enclosure piece with a second edge that includes a second plurality of projecting features configured to interlock with the first plurality of projecting features, wherein, when the first plurality of projecting features interlock with the second plurality of projecting features, a first projecting feature in the first plurality of projecting features overlaps a gap between a second projecting feature in the second plurality of projecting features and a third projecting feature in the second plurality of projecting features.

At least one technical advantage of the disclosed techniques relative to the prior art is that, with the disclosed techniques, water ingress is prevented using a design that prevents water intrusion using interlocking edges. The techniques extend the water intrusion path, preventing water intrusion and strengthening the joining location of the interlocking edges. The techniques described also provide for a stronger and more durable enclosure, increasing resistance to crushing forces relative to enclosures using other types of tabs or connections. These technical advantages provide one or more technological improvements over prior art approaches.

### BRIEF DESCRIPTION OF THE DRAWINGS

So that the manner in which the above recited features of the various embodiments can be understood in detail, a more particular description of the inventive concepts, briefly summarized above, may be had by reference to various embodiments, some of which are illustrated in the appended drawings. It is to be noted, however, that the appended drawings illustrate only typical embodiments of the inventive concepts and are therefore not to be considered limiting of scope in any way, and that there are other equally effective embodiments.
Figure 1A is a diagram illustrating an electronic device according to various embodiments;
Figure 1B is a perspective view of a multi-piece enclosure, according to various embodiments;
Figure 2A is an exploded view of interlocking edge features, according to various embodiments;
Figure 2B is a perspective view of interlocking edge features, according to various embodiments;
Figure 2C is an exterior view of interlocking edge features, according to various embodiments;
Figure 2D is an interior view of interlocking edge features, according to various embodiments;
Figure 3 is an exploded view of a portion of multi-piece enclosure, according to an embodiment;
Figure 4 is a set of side views and section views of interlocking edge features, according to various embodiments;
Figure 5 is a set of section views of interlocking edge features, according to various embodiments;
Figure 6A is an exploded side view of interlocking edge features, according to various embodiments;
Figure 6B is a side view of interlocking edge features, according to various embodiments; and
Figure 7 is a flow diagram of method steps for configuring a multi-piece enclosure, according to various embodiments.

### DETAILED DESCRIPTION

In the following description, numerous specific details are set forth to provide a more thorough understanding of the various embodiments. However, it will be apparent to one of skilled in the art that the inventive concepts may be practiced without one or more of these specific details.

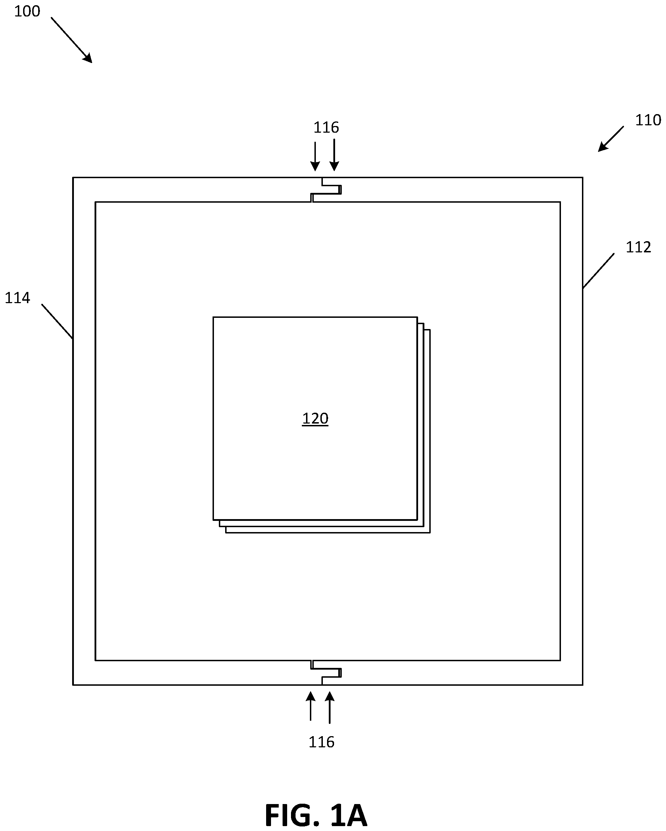

Figure 1A is a diagram illustrating an electronic device 100 with a multi-piece enclosure 110 according to various embodiments. As shown, electronic device 100 includes, without limitation, a multi-piece enclosure 110 and one or more moisture-sensitive components 120 disposed within multi-piece enclosure 110. The multi-piece enclosure 110 includes, without, limitation, two or more enclosure pieces 112 and 114. The two or more enclosure pieces 112 and 114 respectively include, without limitation, at least a portion of the interlocking edge features 116. The interlocking edge features 116 include, without limitation, projecting features and indented features. Indented or recessed edge features accommodate projecting edge features. In some examples, a projecting edge feature fits securely into a recessed edge feature with an engineering fit such as a clearance fit, transition fit, and/or an interference fit. In some examples, tabs, ridges, and other elements on the projecting edge feature and/or the recessed edge feature aid a secure closure of the multi-piece enclosure 110.

Electronic device 100 can be any device or system that includes one or more moisture-sensitive components 120. For example, in some embodiments, electronic device 100 can be a product or system configured for outdoor operation and/or for operation in a damp environment. Examples of such products or systems include, without limitation, a lighting fixture, a control panel or other user interface, a sensing device, and/or the like. Examples of moisture-sensitive components 120 include, without limitation, electrical wiring, lighting elements or bulbs, printed circuit boards, moisture-absorbent materials (e.g., paper), materials susceptible to corrosion, and/or the like.

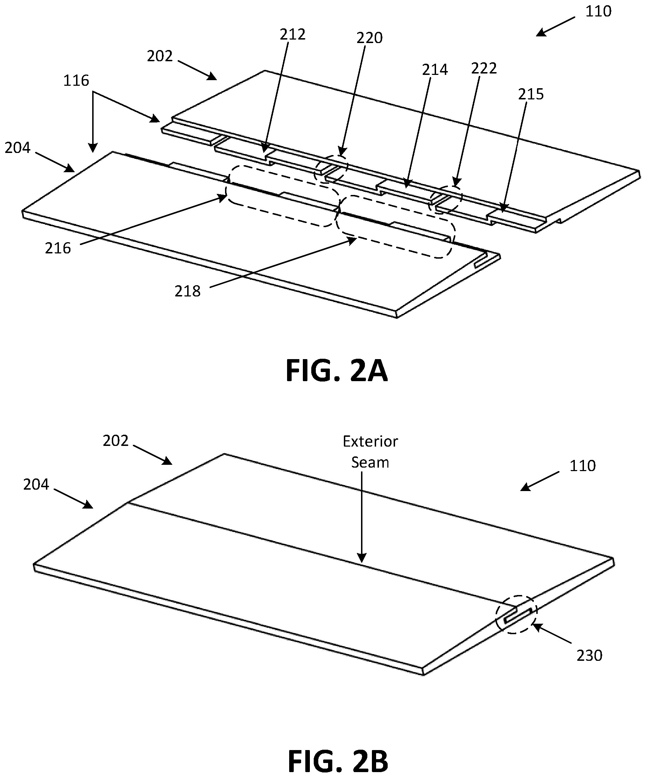

As shown, multi-piece enclosure 110 includes two or more enclosure pieces 112 and 114 that each include a subset of the interlocking edge features 116. In some embodiments, interlocking edge features 116 can provide moisture-resistance equal to or better than an IP54 level. Detailed examples of interlocking edge features 116 are shown and described with respect to Figures 2A-2D and 3-6. In some embodiments, the materials of enclosure pieces 112 and 114 are selected to further improve the moisture resistance of multi-piece enclosure 110. In such embodiments, enclosure pieces 112 and 114 may be formed from one or more hydrophobic materials. The hydrophobic materials include, without limitation, polymers, acrylonitrile butadiene styrene (ABS), polycarbonates, nylon, glass fibers, and combinations thereof. Some hydrophobic materials are treated, texturized and/or coated to provide hydrophobic properties. In some embodiments, enclosure pieces 112 and 114 are held together by one or more mechanical fasteners (such as screws), tabs, or other features. The mechanical fasteners, tabs, and other features can form an integrated part of the multi-piece enclosure 110, or can be a separate component.

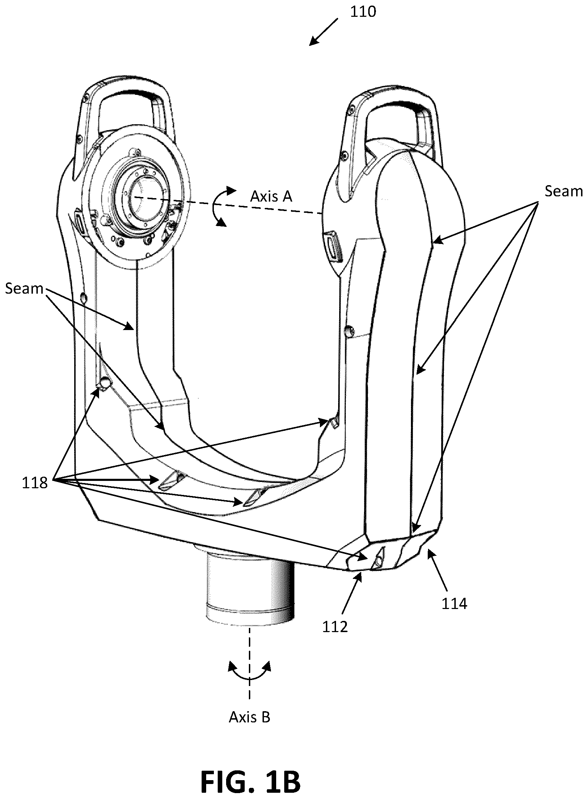

Figure 1B is a perspective view of a multi-piece enclosure 110, according to various embodiments. The shown multi-piece enclosure 110 includes, without, limitation, two or more enclosure pieces 112 and 114. The enclosure pieces 112 and 114 include, without limitation, one or more fastener features 118.

In the embodiment shown in Figure 1B, multi-piece enclosure 110 is implemented as a yoke of an exterior lighting fixture. The yoke implementation shown in Figure 1 enables rotation of a light element (not shown) about two axes including axis A and axis B. In the example shown, axis A is orthogonal to axis B. However, the multi-piece enclosure 110 can form any kind of enclosure for a product or system configured for exterior operation and/or for operation in a damp environment, as discussed.

When assembled, multi-piece enclosure 110 includes two halves corresponding to enclosure pieces 112 and 114, that form a seam along the exterior side of the connection between the enclosure pieces 112 and 114. The seam is indicated in a number of locations in Figure 1B. Thus, when a first enclosure piece 112 is assembled together with a second enclosure piece 114, the seam is formed therebetween. The seam can form a continuous line along an exterior of the multi-piece enclosure 110. This figure shows fastener features 118. The fastener features 118 include tabs, holes, and other elements that form an integrated part of a respective one of the enclosure pieces 112 and 114. Some fastener features 118 are designed to receive or otherwise enable use of separate mechanical fasteners.

Figure 2A is a more detailed view of interlocking edge features 116 included in multi-piece enclosure 110, according to various embodiments. The interlocking edge features 116 include, without limitation, a portion 202 of a first enclosure piece of the multi-piece enclosure 110 and a portion 204 of a second enclosure piece of the multi-piece enclosure 110. Portion 202 includes, without limitation, one or more edge features 212, 214, 215. Additional edge features are shown, but not numbered. Portion 204 includes, without limitation, one or more edge features 216 and 218. The first enclosure piece 112 includes a gap 220 between edge features 212 and 214, and a gap 222 between edge features 214 and 215. The edge features 212, 214, 215, 216, and 218 include projecting features that fit into corresponding indented features on another piece of the multi-piece enclosure 110.

Interlocking edge features 116 are formed on an edge region of portion 202 and on an edge region of a portion 204. Specifically, edge features 212 and 214 are included on the edge region of portion 202 and edge features 216 and 218 are included on the edge region of portion 204. According to various embodiments, interlocking edge features 116 are configured so that the portion 202 and portion 204 assemble together. When portion 202 and portion 204 are assembled, edge features 212, 214, 215, and other edge features of the portion 202 of the first enclosure piece interlock with edge features 216, 218, and other edge features of portion 204 of the second enclosure piece 114.

Further, one or more projecting features on portion 204 (e.g., edge features 216, 218) overlaps a gap between two adjacent projecting features on portion 202 (e.g., edge features 212, 214, 215). For example, the edge feature 216 inserts into and fills the gap 220 between edge features 212 and 214. The edge feature 218 inserts into and fills the gap 222 between edge features 214 and 215. Similarly, one or more projecting features on portion 202 (e.g., edge feature 212) overlaps a gap (not visible) between two adjacent projecting features on portion 204 (e.g., edge features 216 and 218). For example, the edge feature 214 inserts into and fills a gap (not visible) between edge features 216 and 218. Projecting features can be considered projecting relative to a face of an exterior (and/or interior) seam of the corresponding portion of the enclosure.

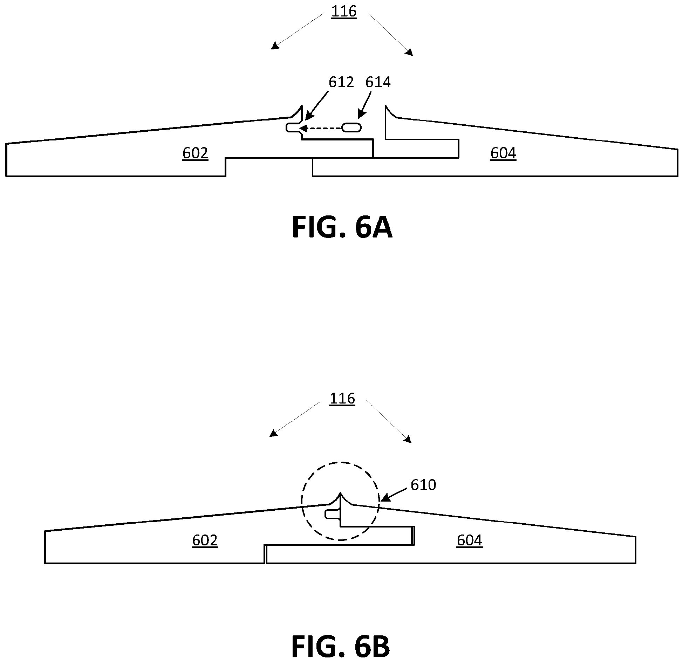

In this way, there is no short, direct path for moisture from an outer surface of multi-piece enclosure 110 to an inner surface of multi-piece enclosure 110 (for example via gaps 220 and 222). This is because, for each gap formed between adjacent projection features on an edge potion of one enclosure piece, a projecting feature on a corresponding edge portion of the other enclosure piece blocks or overlaps with that gap. Consequently, any water micro-drop on the outer surface of multi-piece enclosure 110 that contacts the seam between portion 202 and portion 204 is forced to follow a circuitous path from the outer surface into multi-piece enclosure 110 and cannot pass directly through gap 220 into the interior of multi-piece enclosure 110. A circuitous path is formed in any direction that the water may intrude into the various edge features. The circuitous path can enable a gasketless watertight seal, preventing water intrusion and slowing water intrusion such that the water can evaporate or dry prior to traversing the circuitous path. However, while a gasketed seal can also be provided by the edge features in other embodiments (e.g., Figures 6A, 6B).

Figure 2B shows a perspective view of a multi-piece enclosure 110, according to various embodiments. The interlocking edge features 116 include, without limitation, a portion 202 of a first enclosure piece of the multi-piece enclosure 110 and a portion 204 of a second enclosure piece of the multi-piece enclosure 110. The portion 202 and the portion 204 are connected using interlocking edge features 116 (not shown), forming an exterior seam and an interior seam (not shown). When the portion 202 and the portion 204 are connected, this forms a circuitous path 230 from the exterior seam to an interior of the multi-piece enclosure 110. Any water micro-drop on the outer surface of multi-piece enclosure 110 that contacts the exterior seam between portion 202 and portion 204 is forced to follow the circuitous path 230 from the outer surface into multi-piece enclosure 110.

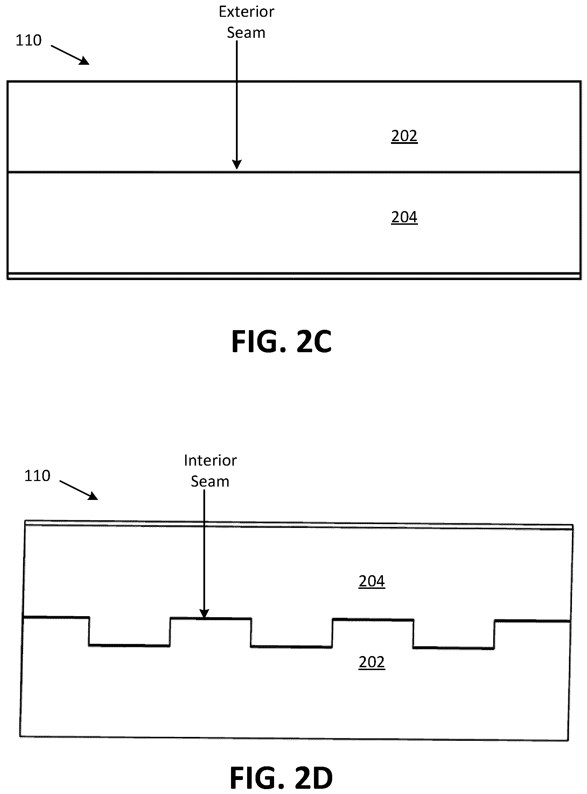

Figure 2C shows an exterior view of a multi-piece enclosure 110, according to various embodiments. The interlocking edge features 116 include, without limitation, a portion 202 of first enclosure piece and a portion 204 of second enclosure piece. The portion 202 and the portion 204 are connected using interlocking edge features 116 (not shown), forming an exterior seam and an interior seam (not shown). The exterior seam forms a continuous line between the portion 202 and the portion 204. The portion 202 and the portion 204 can have little or no space therebetween at the exterior seam.

Figure 2D shows an interior view of a multi-piece enclosure 110, according to various embodiments. The interlocking edge features 116 include, without limitation, a portion 202 of a first enclosure piece and a portion 204 of a second enclosure piece. The portion 202 and the portion 204 are connected using interlocking edge features 116 (not shown), forming an interior seam and an exterior seam (not shown). The interior seam forms a serpentine or circuitous line between the portion 202 and the portion 204. The portion 202 and the portion 204 can have a small space therebetween at the interior seam, which prevents mechanical interference, and enables the exterior seam (not shown) to form a watertight adjacent connection.

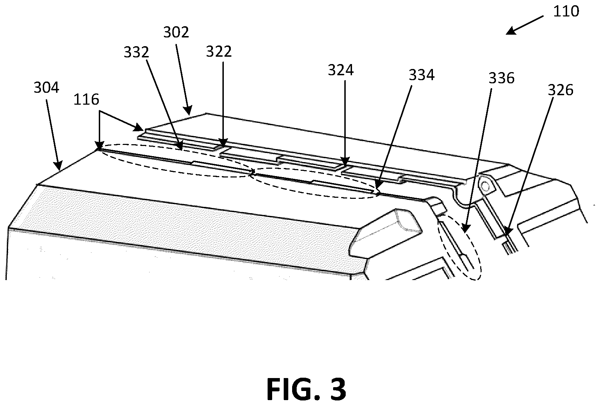

Figure 3 is an exploded view of a portion of multi-piece enclosure 110, according to an embodiment. The interlocking edge features 116 include, without limitation, a portion 302 of a first enclosure piece and a portion 304 of a second enclosure piece. The portion 302 includes, without limitation, gaps 322, 324, and 326. The portion 304 includes, without limitation, edge features 332, 334, and 336. The gaps 322, 324, and 326 are formed between adjacent projecting edge features on an edge of portion 302 of the first enclosure piece. The edge features 332, 334, and 336 are formed on an edge of portion 304 of the second enclosure piece. As shown, each of gaps 322, 324, and 326, corresponds to a center portion of a projecting feature on an edge of the other enclosure piece. For example, gap 322 corresponds to and is blocked by a center portion of the edge feature 332. Gap 322 corresponds to and is blocked by a center portion of the edge feature 334. Gap 326 corresponds to and is blocked by a center portion of the edge feature 336. A center portion provides a connection or transition between two parallel and offset portions of the edge feature, forming a zig-zag or serpentine shaped cross section of the edge feature 336, where the cross section is taken at a plane formed by an exterior (and/or interior) seam.

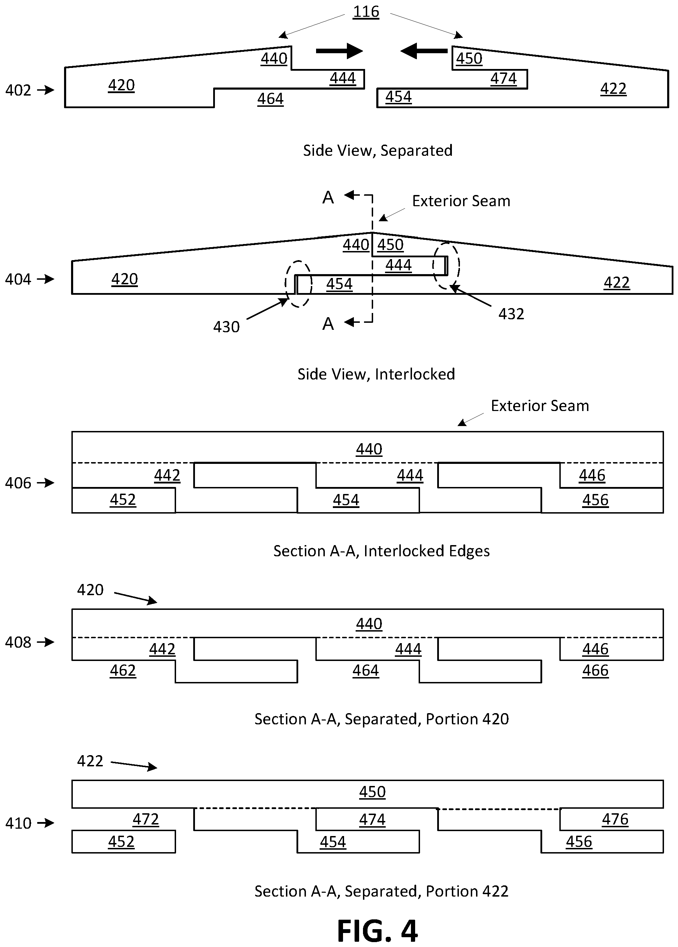

Figure 4 is a set of views of interlocking edge features 116, according to various embodiments. The various views include a separated side view 402, interlocked side view 404, interlocked section view 406, separated section view 408, and separated section view 410. The interlocking edge features 116 include, without limitation, a first enclosure piece and a portion 422 of a second enclosure piece. When the portion 420 and the portion 422 are connected, the overall enclosure has open spaces 430 and 432 between the portion 420 and the portion 422. The portion 420 includes exterior seam edge feature 440 as well as edge features 462, 442, 464, 444, 466, and 446. The portion 422 includes exterior seam edge feature 450 as well as edge features 452, 472, 454, 474, 456, 476.

The separated side view 402 shows interlocking edge features 116 formed using a portion 420 of a first enclosure piece and a portion 422 of a second enclosure piece. The portion 420 of the first enclosure piece and the portion 422 of the second enclosure piece are configured to interlock to provide a watertight exterior seam and a circuitous path that prevents water intrusion into an interior area. When interlocking the portion 420 and the portion 422, the exterior seam edge feature 440 moves towards the exterior seam edge feature 450 until they make solid contact. The recessed edge features accommodate the projecting edge features. For example, edge features 464 and 474 are recessed edge features. Edge features 444 and 454 are projecting edge features. The edge feature 464 accommodates the edge feature 444, and the edge feature 474 accommodates the edge feature 454. The edge feature 444 inserts into the edge feature 464, and the edge feature 454 inserts into the edge feature 474.

The interlocked side view 404 shows the portion 420 and the portion 422, and open spaces 430 and 433 between the portion 420 and the portion 422. The portion 420 of the first enclosure piece and the portion 422 of the second enclosure piece are shown interlocked. The interlocked portions 420 and 422 provide a watertight exterior seam and a circuitous path that prevents water intrusion into an interior area. The open spaces 430 and 433 enable a tighter connection between the exterior seam edge feature 440 of the portion 420 and the exterior seam edge feature 450 of the portion 422. For example, as measured from a plane corresponding to the connection between the exterior seam edge feature 440 and the exterior seam edge feature 450, a set of indented or recessed features in the second enclosure piece are longer than a projection length of the edge features 442, 444, and 446. As a result, the recessed features in the second enclosure piece exceed a depth that accommodates the edge features 442, 444, and 446. Likewise, as measured from the plane corresponding to the connection between the exterior seam edge feature 440 and the exterior seam edge feature 450, another set of indented features or recessed features in the first enclosure piece are longer than a projection length of the edge features 452, 454, and 456. The recessed features in the second enclosure piece exceed a depth that accommodates the edge features 452, 454, and 456.

Interlocked section view 406 corresponds to section A-A of interlocked side view 404. Interlocked section view 406 shows exterior seam edge feature 440 as well as edge features 442, 444, 446 of the portion 420. A center portion of the edge feature 442 fills a gap between the edge features 452 and 454. The gap between edge features 452 and 454 extends in a direction that is perpendicular to a line formed by the exterior seam and within a plane formed by a face of seam edge feature 450. A center portion of the edge feature 444 fills a gap between the edge features 454 and 456. The gap between the edge features 454 and 456 extends in a direction that is perpendicular to a line formed by the exterior seam and within a plane formed by a face of seam edge feature 450. A center portion of the edge feature 454 fills a gap between the edge features 442 and 444. The gap between the edge features 442 and 444 extends in a direction that is perpendicular to a line formed by the exterior seam and within a plane formed by a face of seam edge feature 440. A center portion of the edge feature 456 fills a gap between the edge features 444 and 446. The gap between the edge features 444 and 446 extends in a direction that is perpendicular to a line formed by the exterior seam and within a plane formed by a face of seam edge feature 440. As can be seen in the various views, the edge features ensure that paths from an exterior to the interior are serpentine, zig-zag, or otherwise circuitous. The interlocked techniques, including the center portion's transverse or perpendicular extension relative to a length of the seam provides for a stronger and more durable enclosure, increasing resistance to crushing forces relative to enclosures using other types of tabs or connections.

Separated section view 408 corresponds to a view of portion 420 from section A-A of interlocked side view 404. Separated section view 408 shows exterior seam edge feature 440 as well as edge features 462, 442, 464, 444, 466, and 446 of the portion 420. The gaps between the edge features 442, 444, 446 are seen from this view. The edge features 462, 464, and 466 are recessed edge features that are shaped to accommodate and provide an engineering fit with the edge features 452, 454, and 456 of portion 422. A shape of edge feature 462 is complementary with respect to a shape of edge feature 452. A shape of edge feature 464 is complementary with respect to a shape of edge feature 454. A shape of edge feature 466 is complementary with respect to a shape of edge feature 456. The edge features 442, 444, and 446 are projecting edge features that are shaped to insert into and provide an engineering fit with the edge features 472, 474, and 476 of portion 422. A shape of edge feature 442 is complementary with respect to a shape of edge feature 472. A shape of edge feature 444 is complementary with respect to a shape of edge feature 474. A shape of edge feature 446 is complementary with respect to a shape of edge feature 476.

Separated section view 410 corresponds to a view of portion 422 from section A-A of interlocked side view 404. Separated section view 410 shows edge features 452, 454, 456, and exterior seam edge feature 450 of the portion 422. The gaps between the edge features 452, 454, 456 are seen from this view. The edge features 452, 454, and 456 are projecting edge features that are shaped to insert into and provide an engineering fit with the edge features 462, 464, and 466 of portion 420. The edge features 472, 474, and 476 are recessed edge features that are shaped to accommodate and provide an engineering fit with the edge features 442, 444, and 446 of portion 420.

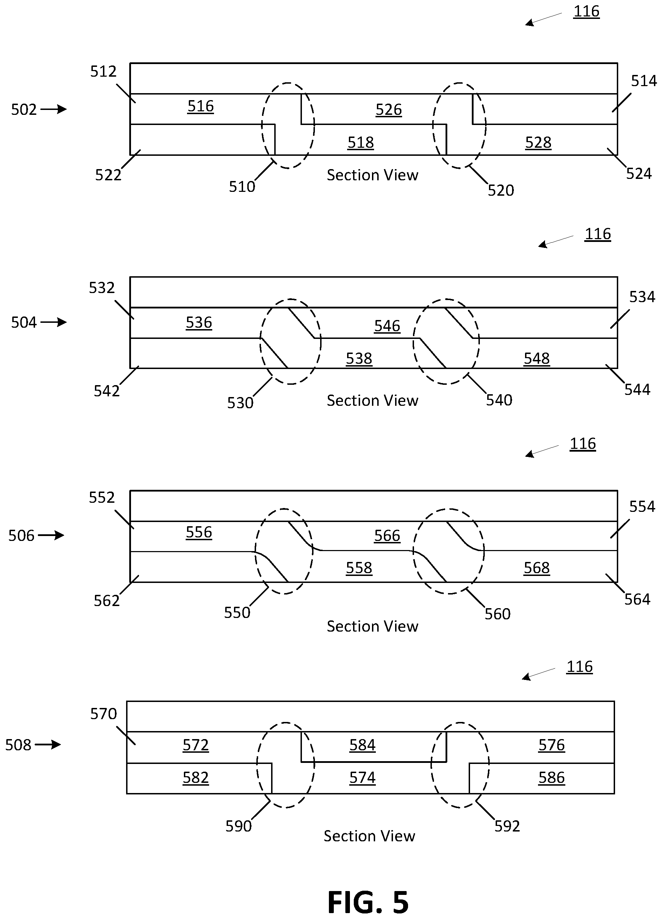

As seen in Figure 4, individual edge features of the portion 420 can have a same shape as individual edge features of the opposite, mating portion 422 when viewed from a cross section. For example, edge feature 442 (and 444) of portion 420 corresponds to a same shape as edge feature 454 (and 456) of portion 422 when viewed from section A-A. Furthermore, a pattern formed by the edge features of the portion 420 can form a same pattern as edge features of the opposite, mating portion 422 when viewed from a cross section. However, in other examples, a pattern formed by the edge features of a portion of a first enclosure piece can form a first pattern that is complementary with a different second pattern formed by edge features of a portion of a second enclosure piece that mates with the first enclosure piece (e.g., Figure 5, section view 508).

Figure 5 is a set of section views of interlocking edge features 116, according to various embodiments. The set of section views include section views 502, 504, 506, and 508. Section view 502 shows interconnected portions of a first enclosure piece and a second enclosure piece. The first enclosure piece includes, without limitation, edge features 512 and 514. The edge feature 512 includes, without limitation, parallel elements 516 and 518 as well as a center portion 510. The second enclosure piece includes, without limitation, edge features 522 and 524. The edge feature 522 includes, without limitation, parallel elements 526 and 528 as well as a center portion 520. Section view 504 shows interconnected portions of a third enclosure piece and a fourth enclosure piece. The third enclosure piece includes, without limitation, edge features 532 and 534. The edge feature 532 includes, without limitation, parallel elements 536 and 538 as well as a center portion 530. The fourth enclosure piece includes, without limitation, edge features 542 and 544. The edge feature 542 includes, without limitation, parallel elements 546 and 548 as well as a center portion 540. Section view 506 shows interconnected portions of a fifth enclosure piece and a sixth enclosure piece. The fifth enclosure piece includes, without limitation, edge features 552 and 554. The edge feature 552 includes, without limitation, parallel elements 556 and 558 as well as a center portion 550. The sixth enclosure piece includes, without limitation, edge features 562 and 564. The edge feature 562 includes, without limitation, parallel elements 566 and 568 as well as a center portion 560. Section view 508 shows interconnected portions of a seventh enclosure piece and an eighth enclosure piece. The seventh enclosure piece includes, without limitation, edge feature 570. The edge feature 570 includes, without limitation, parallel elements 572, 574, and 576, as well as a center portions 590 and 592. The eighth enclosure piece includes, without limitation, edge features 582, 584, and 586.

The section view 502 shows an example of interlocking edge features 116 that have ninety degree center portions 510 and 520. The edge feature 512 includes a center portion 510 that connects the parallel elements 516 and 518. The edge feature 512 forms a projecting zig-zag or serpentine shape that fits into recessed edge features and/or gaps of a mating or opposite edge of the of the interlocking edge features 116. The center portion 510 forms a ninety degree angle with each of the parallel elements 516 and 518 of the edge feature 512. The edge feature 524 includes a center portion 520 that connects the parallel elements 526 and 528. The edge feature 524 forms a projecting zig-zag or serpentine shape that fits into recessed edge features and/or gaps of a mating edge of the of the interlocking edge features 116. The center portion 520 forms a 90 degree angle with each of the parallel elements 526 and 528 of the edge feature 524.

The section view 504 shows an example of interlocking edge features 116 that have center portions 530 and 540 that form obtuse angles (e.g., greater than ninety degrees). Center portions form any angle with respect to parallel elements, including angles greater than, equal to, and less than ninety degrees. The edge feature 532 includes a center portion 530 that connects the parallel elements 536 and 538. The edge feature 532 forms a projecting zig-zag or serpentine shape that fits into recessed edge features and/or gaps of a mating edge of the of the interlocking edge features 116. The center portion 530 forms an angle greater than ninety degrees with each of the parallel elements 536 and 538 of the edge feature 532. The edge feature 544 includes a center portion 540 that connects the parallel elements 546 and 548. The edge feature 544 forms a projecting zig-zag or serpentine shape that fits into recessed edge features and/or gaps of a mating edge of the of the interlocking edge features 116. The center portion 540 forms an angle greater than ninety degrees with each of the parallel elements 526 and 528 of the edge feature 524.

The section view 506 shows an example of interlocking edge features 116 that have curved center portions 550 and 560. The edge feature 552 includes a center portion 550 that connects the parallel elements 556 and 558. The edge feature 552 forms a projecting zig-zag or serpentine shape that fits into recessed edge features and/or gaps of a mating edge of the of the interlocking edge features 116. The center portion 550 provides a curved connection between the parallel elements 556 and 558 of the edge feature 552. The edge feature 564 includes a center portion 560 that connects the parallel elements 566 and 568. The edge feature 564 forms a projecting zig-zag or serpentine shape that fits into recessed edge features and/or gaps of a mating edge of the of the interlocking edge features 116. The center portion 560 provides a curved connection between the parallel elements 566 and 568 of the edge feature 564.

The section view 508 shows an example of interlocking edge features 116 that are asymmetrically complementary. A pattern formed by the edge feature 570 (and recessed features) of the seventh enclosure piece forms a first pattern that is complementary with a different second pattern formed by edge features 582, 584, and 586 (and recessed features) of a portion of the eighth enclosure piece. The edge feature 570 includes a center portion 590 that connects the parallel elements 572 and 574. The edge feature 570 also includes a center portion 592 that connects the parallel elements 574 and 576. The edge feature 570 forms a projecting zig-zag or serpentine shape that fits into recessed edge features and/or gaps of a mating edge of the of the interlocking edge features 116. The center portion 590 fills a gap between edge features 582 and 584. The center portion 592 fills a gap between edge features 584 and 586. While the center portions 590 and 592 form ninety-degree angles, the center portions 590 and 592 can form any angle with respect to parallel elements, including angles greater than, equal to, and less than ninety degrees. The center portions 590 and 592 can additionally or alternatively provide a curved transition.

Figure 6A is an exploded side view of interlocking edge features 116, according to various embodiments. The interlocking edge features 116 include, without limitation, a portion 602 of a first enclosure piece of the multi-piece enclosure 110 and a portion 604 of a second enclosure piece of the multi-piece enclosure 110. The portion 602 and the portion 604 form an exterior seam of the multi-piece enclosure 110. The portion 602 includes, without limitation, a gasket opening 612 in an exterior seam edge feature of the portion 602. The gasket opening 612 is shaped to retain a gasket 614. The portion 604 includes, without limitation, an exterior seam edge feature that forms an exterior seam with the exterior seam edge feature of portion 602 when the interlocking edge features 116 are interlocked. In this example, the portion 602 is configured to hold the gasket 614 against a flat face of an exterior seam edge feature of portion 604. In other examples, the exterior seam edge feature of portion 604 includes a convex or concave shape that mates or connects with the gasket 614 to form a watertight seal. The gasket opening 612 and the gasket 614 can extend along the exterior seam edge feature of the portion 602, following the exterior seam.

Figure 6B is a side view of interlocking edge features 116, according to various embodiments. The interlocking edge features 116 include, without limitation, a portion 602 of a first enclosure piece of the multi-piece enclosure 110 and a portion 604 of a second enclosure piece of the multi-piece enclosure 110. The portion 602 and the portion 604 forms a peaked seam area 610 relative to an exterior seam of the multi-piece enclosure 110. The peaked seam area 610 increases water resistance and prevents water intrusion for the multi-piece enclosure 110 by encouraging water roll-off. The peaked seam area 610 has forms a curved, concave structure on each of the portion 602 and the portion 604 when viewed from an exterior of the multi-piece enclosure 110. The portion 602 also includes a gasket opening in an exterior seam edge feature that is shaped to retain a gasket. In this example, the portion 602 holds the gasket against a flat face of an exterior seam edge feature of portion 604. In other examples, the exterior seam edge feature of portion 604 includes a convex or concave shape that mates with the gasket. While shown as a curved, concave structure, the peaked seam area 610 can also form a reflex angle at an exterior seam, when viewed from an exterior (see Figure 4, interlocked side view 404). While shown as part of a structure that includes a gasket, the peaked seam area 610 can enable a gasketless watertight seal, reducing water pooling, preventing water intrusion, and slowing water intrusion along the exterior seam. For example, the gasket and the gasket opening in the exterior seam edge feature of the portion 602 can be omitted.

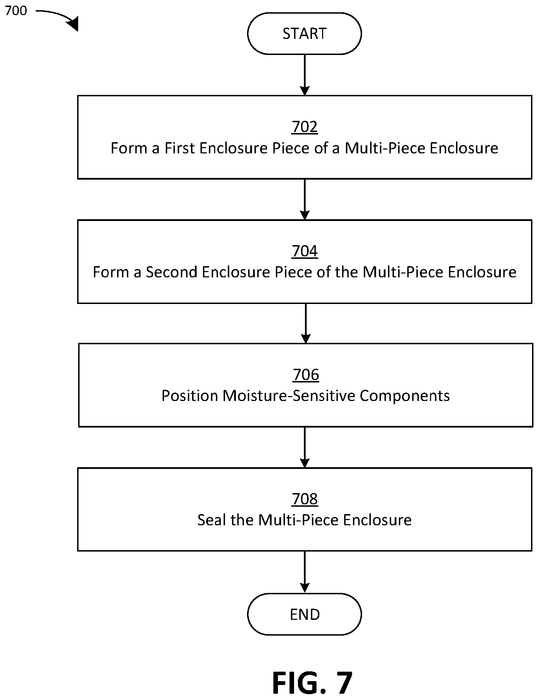

Figure 7 is a flow diagram of method steps for configuring a multi-piece enclosure 110, according to various embodiments. Although the method steps are described in conjunction with the multi-piece enclosures 110 of Figures 1A, 1B, and 3, as well as the interlocking features 116 of Figures 2A-2D, and 4-6, persons of ordinary skill in the art will understand that any multi-piece enclosure 110, any interlocking features 116, and any system configured to perform the method steps, in any order, is within the scope of the invention.

As shown, a method 700 begins at step 702, where an enclosure fabrication system and/or process forms a first enclosure piece of a multi-piece enclosure 110. The enclosure fabrication system forms the first enclosure piece of the multi-piece enclosure 110 using a process that includes one or more of molding, casting, printing, machining, vacuum forming, thermoforming, and so on. The first enclosure piece of the multi-piece enclosure 110 includes interlocking edge features 116. Interlocking edge features of the first enclosure piece include projecting features and/or indented features. The projecting edge features are configured to provide an engineering fit with recessed edge features of a second enclosure piece. The recessed edge features are configured to provide an engineering fit with projecting edge features of the second enclosure piece.

At step 704, the enclosure fabrication system and/or process forms a second enclosure piece of the multi-piece enclosure 110. The enclosure fabrication system forms the second enclosure piece of the multi-piece enclosure 110 using a process that includes one or more of molding, casting, printing, machining, vacuum forming, thermoforming, and so on. The second enclosure piece of the multi-piece enclosure 110 includes interlocking edge features 116. Interlocking edge features 116 of the second enclosure piece include projecting features and/or indented features. The projecting edge features are configured to provide an engineering fit with recessed edge features of the first enclosure piece. The recessed edge features are configured to provide an engineering fit with projecting edge features of the first enclosure piece.

At step 706, the enclosure fabrication system and/or process positions moisture-sensitive components 120 such as electronic circuits, electrical wiring, lighting elements or bulbs, printed circuit boards, moisture-absorbent materials, materials susceptible to corrosion, and/or the like. The moisture-sensitive components 120 are positioned relative to or attached to at least one of the first enclosure piece and the second enclosure piece of the multi-piece enclosure 110.

At step 708, the enclosure fabrication system and/or process seals the multi-piece enclosure 110. The process connects the interlocking edge features 116 of the first enclosure piece and the second enclosure piece to seal the multi-piece enclosure 110, forming a watertight seal. The moisture-sensitive components 120 are sealed within the multi-piece enclosure 110.

In sum, an enclosure provides a watertight seal. The enclosure uses at least a first enclosure piece and a second enclosure piece. The first enclosure piece includes a first edge having a first set of edge features. The second enclosure piece includes a second edge having a second set of edge features configured to interlock with the first set of edge features. When the first set of edge features interlock with the second set of edge features, a first projecting feature in the first set of edge features overlaps a gap between a second projecting feature in the second plurality of edge features and a third projecting feature in the second plurality of edge features.

At least one technical advantage of the disclosed techniques relative to the prior art is that, with the disclosed techniques, water ingress is prevented using a design that prevents water intrusion using interlocking edges. The interlocking edges extend the water intrusion path, preventing water intrusion and strengthening the joining location of the interlocking edges. These technical advantages provide one or more technological improvements over prior art approaches.

Aspects of the subject matter described herein are set out in the following numbered clauses.
1. In some embodiments, an enclosure for one or more moisture-sensitive components, the enclosure comprises a first enclosure piece with a first edge that includes a first plurality of edge features, and a second enclosure piece with a second edge that includes a second plurality of edge features configured to interlock with the first plurality of edge features, wherein, when the first plurality of edge features interlock with the second plurality of edge features, a first projecting feature in the first plurality of edge features overlaps a gap between a second projecting feature in the second plurality of edge features and a third projecting feature in the second plurality of edge features, the first projecting feature comprising a zig-zag shaped cross section.
2. The enclosure of clause 1, wherein the first enclosure piece comprises a hydrophobic material.
3. The enclosure of clauses 1 or 2, wherein the second enclosure piece comprises the hydrophobic material.
4. The enclosure of any of clauses 1-3, wherein the enclosure comprises a yoke of a lighting fixture.
5. The enclosure of any of clauses 1-4, wherein, when the first plurality of edge features interlock with the second plurality of edge features, the first projecting feature in the first plurality of edge features inserts into a recessed feature in the second plurality of edge features.
6. The enclosure of any of clauses 1-5, wherein the second projecting feature comprises the zig-zag shape, and the third projecting feature comprises the zig-zag shape.
7. The enclosure of any of clauses 1-6, wherein the enclosure is a watertight gasketless enclosure.
8. The enclosure of any of clauses 1-7, wherein, when the first plurality of edge features interlock with the second plurality of edge features, the enclosure comprises a peaked seam area between the first enclosure piece and the second enclosure piece.
9. The enclosure of any of clauses 1-8, wherein the first projecting feature comprises a first projecting element, a second projecting element parallel to the first projecting element, and a center portion that connects the first projecting element to the second projecting element.
10. The enclosure of any of clauses 1-9, wherein the center portion forms one of a ninety degree angle with each of the first projecting element and the second projecting element, an obtuse angle with each of the first projecting element and the second projecting element, or a curved transition with each of the first projecting element and the second projecting element.
11. In some embodiments, a device comprises one or more moisture-sensitive components, and an enclosure for the one or more moisture-sensitive components, the enclosure comprising a first enclosure piece with a first edge that includes a first plurality of edge features, and a second enclosure piece with a second edge that includes a second plurality of edge features configured to interlock with the first plurality of edge features, wherein, when the first plurality of edge features interlock with the second plurality of edge features, a first projecting feature in the first plurality of edge features overlaps a gap between a second projecting feature in the second plurality of edge features and a third projecting feature in the second plurality of edge features, the first projecting feature comprising a zig-zag shaped cross section.
12. The device of clause 11, wherein the first enclosure piece comprises a hydrophobic material.
13. The device of clauses 11 or 12, wherein the second enclosure piece comprises the hydrophobic material.
14. The device of any of clauses 11-13, wherein the enclosure comprises a yoke of a lighting fixture.
15. The device of any of clauses 11-14, wherein, when the first plurality of edge features interlock with the second plurality of edge features, the first projecting feature in the first plurality of edge features inserts into a recessed feature in the second plurality of edge features.
16. The device of any of clauses 11-15, wherein the second projecting feature comprises the zig-zag shape, and the third projecting feature comprises the zig-zag shape.
17. The device of any of clauses 11-16, wherein the enclosure is a watertight gasketless enclosure.
18. The device of any of clauses 11-17, wherein, when the first plurality of edge features interlock with the second plurality of edge features, the enclosure comprises a peaked seam area between the first enclosure piece and the second enclosure piece.
19. The device of any of clauses 11-18, wherein the first projecting feature comprises a first projecting element, a second projecting element parallel to the first projecting element, and a center portion that connects the first projecting element to the second projecting element.
20. The device of any of clauses 11-19, wherein the center portion forms one of a ninety degree angle with each of the first projecting element and the second projecting element, an obtuse angle with each of the first projecting element and the second projecting element, or a curved transition with each of the first projecting element and the second projecting element.

Any and all combinations of any of the claim elements recited in any of the claims and/or any elements described in this application, in any fashion, fall within the contemplated scope of the present invention and protection.

The descriptions of the various embodiments have been presented for purposes of illustration, but are not intended to be exhaustive or limited to the embodiments disclosed. Many modifications and variations will be apparent to those of ordinary skill in the art without departing from the scope and spirit of the described embodiments.

Aspects of the present embodiments can be embodied as a system, method or computer program product. Accordingly, aspects of the present disclosure can take the form of an entirely hardware embodiment, an entirely software embodiment (including firmware, resident software, micro-code, etc.) or an embodiment combining software and hardware aspects that can all generally be referred to herein as a "module," a "system," or a "computer." In addition, any hardware and/or software technique, process, function, component, engine, module, or system described in the present disclosure can be implemented as a circuit or set of circuits. Furthermore, aspects of the present disclosure can take the form of a computer program product embodied in one or more computer readable medium(s) having computer readable program code embodied thereon.

Any combination of one or more computer readable medium(s) can be utilized. The computer readable medium can be a computer readable signal medium or a computer readable storage medium. A computer readable storage medium can be, for example, but not limited to, an electronic, magnetic, optical, electromagnetic, infrared, or semiconductor system, apparatus, or device, or any suitable combination of the foregoing. More specific examples (a non-exhaustive list) of the computer readable storage medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium can be any tangible medium that can contain, or store a program for use by or in connection with an instruction execution system, apparatus, or device.

Aspects of the present disclosure are described above with reference to flowchart illustrations and/or block diagrams of methods, apparatus (systems) and computer program products according to embodiments of the disclosure. It will be understood that each block of the flowchart illustrations and/or block diagrams, and combinations of blocks in the flowchart illustrations and/or block diagrams, can be implemented by computer program instructions. These computer program instructions can be provided to a processor of a general purpose computer, special purpose computer, or other programmable data processing apparatus to produce a machine. The instructions, when executed via the processor of the computer or other programmable data processing apparatus, enable the implementation of the functions/acts specified in the flowchart and/or block diagram block or blocks. Such processors can be, without limitation, general purpose processors, special-purpose processors, application-specific processors, or field-programmable gate arrays.

The flowchart and block diagrams in the figures illustrate the architecture, functionality, and operation of possible implementations of systems, methods and computer program products according to various embodiments of the present disclosure. In this regard, each block in the flowchart or block diagrams can represent a module, segment, or portion of code, which comprises one or more executable instructions for implementing the specified logical function(s). It should also be noted that, in some alternative implementations, the functions noted in the block can occur out of the order noted in the figures. For example, two blocks shown in succession can, in fact, be executed substantially concurrently, or the blocks can sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts, or combinations of special purpose hardware and computer instructions.

While the preceding is directed to embodiments of the present disclosure, other and further embodiments of the disclosure can be devised without departing from the basic scope thereof, and the scope thereof is determined by the claims that follow.

## Claims

1. An enclosure for one or more moisture-sensitive components, the enclosure comprising:
a first enclosure piece with a first edge that includes a first plurality of edge features; and
a second enclosure piece with a second edge that includes a second plurality of edge features configured to interlock with the first plurality of edge features,
wherein, when the first plurality of edge features interlock with the second plurality of edge features, a first projecting feature in the first plurality of edge features overlaps a gap between a second projecting feature in the second plurality of edge features and a third projecting feature in the second plurality of edge features, the first projecting feature comprising a zig-zag shaped cross section.

2. The enclosure of claim 1, wherein the first enclosure piece comprises a hydrophobic material.

3. The enclosure of claim 2, wherein the second enclosure piece comprises the hydrophobic material.

4. The enclosure of any preceding claim, wherein the enclosure comprises a yoke of a lighting fixture.

5. The enclosure of any preceding claim, wherein, when the first plurality of edge features interlock with the second plurality of edge features, the first projecting feature in the first plurality of edge features inserts into a recessed feature in the second plurality of edge features.

6. The enclosure of any preceding claim, wherein the second projecting feature comprises the zig-zag shape, and the third projecting feature comprises the zig-zag shape.

7. The enclosure of any preceding claim, wherein the enclosure is a watertight gasketless enclosure.

8. The enclosure of any preceding claim, wherein, when the first plurality of edge features interlock with the second plurality of edge features, the enclosure comprises a peaked seam area between the first enclosure piece and the second enclosure piece.

9. The enclosure of any preceding claim, wherein the first projecting feature comprises: a first projecting element, a second projecting element parallel to the first projecting element, and a center portion that connects the first projecting element to the second projecting element.

10. The enclosure of claim 9, wherein the center portion forms one of: a ninety degree angle with each of the first projecting element and the second projecting element, an obtuse angle with each of the first projecting element and the second projecting element, or a curved transition with each of the first projecting element and the second projecting element.

11. A device, comprising:
one or more moisture-sensitive components; and
an enclosure for the one or more moisture-sensitive components, the enclosure comprising:
a first enclosure piece with a first edge that includes a first plurality of edge features; and
a second enclosure piece with a second edge that includes a second plurality of edge features configured to interlock with the first plurality of edge features,
wherein, when the first plurality of edge features interlock with the second plurality of edge features, a first projecting feature in the first plurality of edge features overlaps a gap between a second projecting feature in the second plurality of edge features and a third projecting feature in the second plurality of edge features, the first projecting feature comprising a zig-zag shaped cross section.

12. The device of claim 11, wherein the enclosure is the enclosure as mentioned in any of claims 2 to 10.
